(19) Europäisches Patentamt
European Patent Office
Office européen des brevets

(11) **EP 2 341 358 B1**

(12) **FASCICULE DE BREVET EUROPEEN**

(45) Date de publication et mention
de la délivrance du brevet:
**05.09.2012 Bulletin 2012/36**

(51) Int Cl.:
***G01R 33/00*** *(2006.01)*     ***G01R 33/09*** *(2006.01)*

(21) Numéro de dépôt: **10195167.1**

(22) Date de dépôt: **15.12.2010**

(54) **Réalisation d'un dispositif à structures magnétiques formées sur un même substrat et ayant des orientations d'aimantation respectives différentes**

Herstellung einer magnetischen Struktur auf ein und demselben Substrat mit unterschiedlichen Magnetisierungsrichtungen

Manufacturing of a magnetic structure on one and the same substrate with different magnetization directions

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2009 FR 0959312**

(43) Date de publication de la demande:
**06.07.2011 Bulletin 2011/27**

(73) Titulaire: **Commissariat à l'Énergie Atomique et aux Énergies Alternatives
75015 Paris (FR)**

(72) Inventeur: **Redon, Olivier
38170 Seyssinet Pariset (FR)**

(74) Mandataire: **Ilgart, Jean-Christophe
BREVALEX
95 rue d'Amsterdam
75378 Paris Cedex 8 (FR)**

(56) Documents cités:
**US-A1- 2004 137 275**

**Description**

**DOMAINE TECHNIQUE**

L'invention concerne le domaine des dispositifs dotés de plusieurs structures aimantées formées sur un substrat et prévoit un procédé amélioré de réalisation de zones magnétiques ayant des aimantations respectives d'orientations différentes sur un même support, comme décrit dans la demande de brevet américaine US 2004/013 7275.

Elle trouve des applications dans le domaine des dispositifs de détection et/ou mesure de champ magnétique, par exemple celui des capteurs magnétiques de type MEMS (MEMS pour Micro-systèmes électro-mécaniques) ou NEMS (NEMS pour Nano-systèmes électro-mécaniques), adaptés pour la mesure de champs magnétiques selon plusieurs axes, en particulier selon trois axes.

Elle s'applique par exemple à la réalisation de dispositifs de mesure du champ magnétique terrestre tels que les dispositifs ayant une fonction de boussole.

**ART ANTERIEUR**

Il est connu de réaliser un capteur magnétique capable de détecter un champ magnétique sur 3 axes.

Pour cela, il s'avère nécessaire de réaliser des zones formant aimant, ayant des directions d'aimantation orthogonales entre elles.

La fabrication d'un capteur comportant des zones d'aimant ayant des orientations d'aimantation différentes sur un même substrat pose problème.

Il est connu, selon une première approche, de déposer successivement des zones d'orientations d'aimantation différentes sur un même substrat, ou selon une deuxième approche, de former des zones d'orientations d'aimantation identiques sur un même substrat, puis de réaliser un chauffage local d'au moins une de ces zones afin de modifier son orientation d'aimantation.

La seconde approche peut s'avérer très longue à mettre en oeuvre lorsque le nombre de zones d'aimantation à réaliser sur le substrat est important et donc difficilement applicable à l'échelle industrielle.

La première approche a pour inconvénient qu'elle nécessite d'utiliser des matériaux différents ayant des températures de recuit sous champ magnétique suffisamment éloignées, ce qui limite le choix des matériaux et rend complexe le procédé de fabrication.

Il se pose le problème de trouver un nouveau procédé de réalisation, sur un même substrat, de zones ayant des orientations d'aimantation respectives différentes et fixes.

**EXPOSÉ DE L'INVENTION**

L'invention concerne tout d'abord un procédé de réalisation d'un dispositif comportant des blocs magnétiques reposant sur un substrat, les blocs magnétiques ayant des directions d'aimantation respectives différentes,

le procédé comprenant des étapes de :

a) formation dans un empilement d'une ou plusieurs couches d'au moins un matériau anti-ferromagnétique et d'une ou plusieurs couches d'au moins un matériau ferromagnétique reposant sur un substrat, d'au moins un premier bloc et d'au moins un deuxième bloc longilignes disjoints s'étendant respectivement selon une première direction principale et selon une deuxième direction principale, la première et la deuxième direction principales réalisant entre elles un premier angle $\alpha$ non-nul,

b) recuit desdits blocs à une température supérieure ou égale à une température adaptée, prévue en fonction du matériau antiferromagnétique.

Ladite température adaptée correspond à la température de mise en ordre du matériau antiferromagnétique lorsque le matériau anti-ferromagnétique est non-ordonné magnétiquement. Un matériau anti-ferromagnétique non-ordonné ne présente pas de couplage d'échange après dépôt sur un matériau ferro-magnétique.

Cette température adaptée correspond à la température de blocage, c'est-à-dire la température au delà de laquelle il n'y a plus de couplage d'échange entre un matériau antiferromagnétique et un matériau ferromagnétique en contact lorsque le matériau anti-ferromagnétique est ordonné magnétiquement.

Cette température adaptée peut également correspondre à la température de Néel c'est-à-dire la température au dessus de laquelle le matériau anti-ferromagnétique devient paramagnétique.

Un matériau anti-ferromagnétique ordonné présente un couplage d'échange après dépôt sur un matériau ferromagnétique.

De par la forme longiligne des blocs, l'aimantation peut naturellement s'aligner le long de leurs directions principales, c'est-à-dire la direction dans laquelle leur longueur est mesurée, lorsqu'on effectue un recuit approprié.

Après recuit, au cours du refroidissement, les aimantations respectives des blocs se figent.

L'empilement peut être formé à l'étape a) de manière à comprendre au moins une couche ferromagnétique située entre, et en contact, avec deux couches antiferromagnétiques.

Cela peut permettre de bloquer l'aimantation de ladite couche de matériau ferromagnétique F dans une direction définie lors du recuit de mise en ordre.

Selon une possibilité de mise en oeuvre, le premier bloc et le deuxième bloc peuvent être de forme parallépipédique.

Selon une autre possibilité de mise en oeuvre, le premier bloc et/ou le deuxième bloc peuvent être eux même sous forme de sous blocs parallépipédique disjoints et parallèles entre eux.

Le procédé peut comprendre en outre, lors du recuit, l'application d'un champ magnétique orienté dans une direction réalisant un deuxième angle θ non-nul avec ladite première direction principale, dont on fait varier l'intensité au cours du recuit.

L'application du champ magnétique peut permettre de saturer l'aimantation dans chaque bloc et ainsi éviter l'apparition de domaines magnétiques.

On fait varier l'intensité du champ magnétique appliqué lors du recuit de manière à aligner simultanément les aimantations des blocs magnétiques d'orientation différentes au plus proche de leurs directions principales respectives, tout en conservant une orientation du champ magnétique selon un angle donné non-nul par rapport aux directions principales des blocs.

Selon une possibilité de mise en oeuvre, le premier angle α, c'est-à-dire l'angle que font les blocs entre eux, peut être de 90˚, tandis que le deuxième angle θ, c'est-à-dire l'angle entre la direction du champ magnétique et la direction principale du premier bloc, peut être de 45˚.

Cela permet de mettre en oeuvre des blocs magnétiques ayant des aimantations respectives orientées à 90˚ l'une de l'autre.

A l'étape b), lors de l'application du champ magnétique, on peut appliquer tout d'abord un champ magnétique d'intensité donnée supérieure à celle du champ magnétique de saturation des blocs selon leur axe difficile d'aimantation.

On peut ensuite diminuer l'intensité donnée de sorte que les modules respectifs d'une projection du champ magnétique selon la première direction principale et d'une projection du champ magnétique selon la deuxième direction principale sont supérieurs à une valeur de champ de saturation $H_L$ des blocs selon leur axe facile d'aimantation, alors que les modules respectifs d'une projection du champ magnétique perpendiculaire à la première direction principale et d'une projection du champ magnétique perpendiculaire à la deuxième direction principale sont inférieurs à une valeur de champ de saturation $H_w$ des blocs selon leur axe difficile d'aimantation.

La température peut être ensuite diminuée, par exemple jusqu'à la température ambiante sous cette intensité de champ magnétique afin de piéger les directions d'aimantation desdits matériaux ferromagnétiques par les matériaux anti-ferromagnétiques au plus proche des directions principales desdits blocs magnétiques.

On peut avoir :

$$H_L = \frac{Wt}{L^2}\left[\ln\left(\frac{4L}{W}\right) - 1\right] * 4 * \pi * Ms$$

$$Hw = 4 * \pi * Ms * t * \left[\frac{1}{t+W} - \frac{W}{L^2}\left[\ln\left(\frac{4L}{W}\right) - 1\right]\right]$$

avec t l'épaisseur du premier bloc, L la longueur du premier bloc, W la largeur du premier bloc, Ms l'aimantation à saturation.

A l'étape a), on peut former en outre dans l'empilement au moins un troisième bloc longiligne s'étendant selon la première direction principale.

L'invention concerne également un procédé de réalisation d'un capteur magnétique tri-axes comprenant la mise en oeuvre d'un procédé tel que défini précédemment.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- les figures 1A-1C, et 2 illustrent un exemple de procédé de réalisation d'un dispositif doté de plusieurs blocs magnétiques formés sur un même substrat et ayant des directions d'aimantation différentes,
- les figures 3A-3B, illustrent un dispositif comprenant des blocs magnétiques formés à partir d'un empilement de couches ferromagnétiques et anti-ferromagnétiques, chaque bloc étant subdivisé en sous-blocs magnétiques distincts de forme parallépipédique,
- la figure 4 illustre un exemple de capteur tri-axes mis en oeuvre à l'aide d'un procédé de réalisation suivant l'invention.

Des parties identiques, similaires ou équivalentes des différentes figures peuvent porter les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

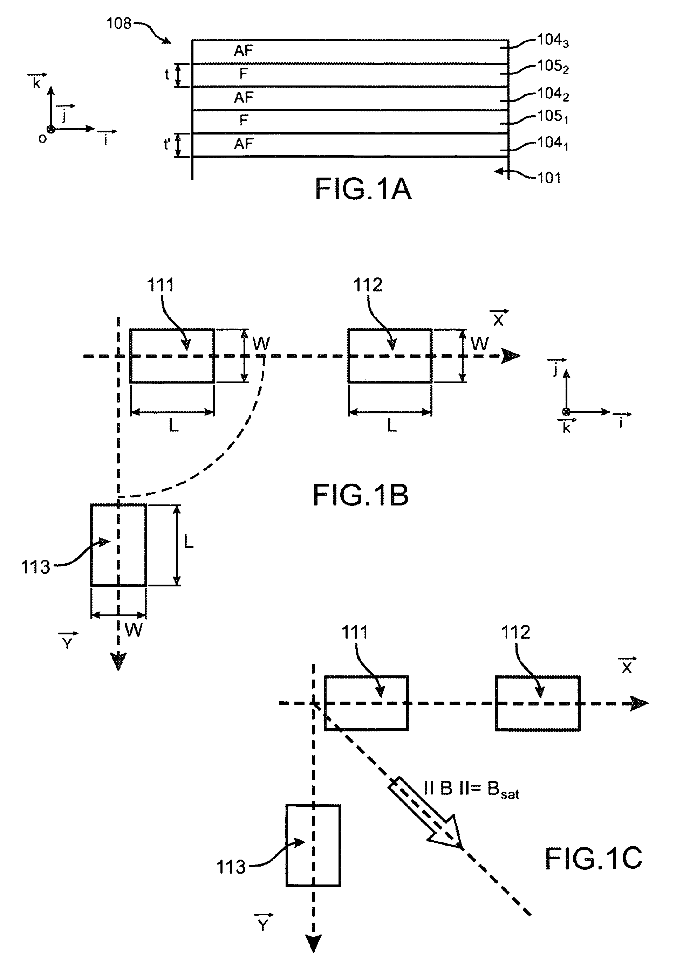

Un exemple de procédé de réalisation d'un dispositif comportant sur un même substrat, des zones d'orientations magnétiques différentes, va à présent être donné en liaison avec les figures 1A-1C, 2, 3A-3B.

La première étape de ce procédé illustrée sur la figure 1A, peut consister à réaliser un empilement de couches magnétiques sur un support 101, qui peut être par exemple une couche de silicium d'un substrat SOI (SOI pour « silicon on insulator » ou « silicium sur isolant »).

L'empilement est formé d'une alternance de couches $104_1,...,104_m$ (avec m un entier pris à titre d'exemple égal à 3 sur la figure 1A) à base d'un matériau anti-ferromagnétique AF et de couches $105_1,...,105_n$ avec n un entier compris par exemple entre 4 et 25 (sur la figure 1A, nest pris à titre d'exemple égal à 2) à base d'un matériau ferromagnétique F.

Le matériau ferromagnétique F peut être formé à base d'un matériau magnétique doux, ayant une forte aimantation à saturation Ms typiquement supérieure à 1000 emu/cm$^3$. Le matériau ferromagnétique F peut être par exemple à base d'un alliage de Fe, de Co, et de Ni.

Le matériau antiferromagnétique AF peut, quant à lui, être un alliage à base de Mn, par exemple du type NiMn, ou PtMn, ou PdPtMn. Selon d'autres exemples, le matériau antiferromagnétique AF peut être du FeMn, ou de l'IrMn, ou du NiO, ou du $Fe_2O_3$.

L'empilement 108 peut être formé de sorte que chaque couche à base de matériau ferromagnétique F est située entre deux couches de matériau anti-ferromagnétique AF.

Lorsque des couches de matériau antiferromagnétique AF sont placées de part et d'autre d'une couche de matériau ferromagnétique F un couplage d'échange aux interfaces entre matériau anti-ferromagnétique et matériau ferromagnétique pourra permettre de bloquer l'aimantation de la couche de matériau ferromagnétique F intercalée dans une direction définie lors du recuit de mise en ordre.

Les couches $104_1,...,104_n$ à base de matériau anti-ferromagnétique AF peuvent avoir une épaisseur t' (mesurée dans une direction orthogonale à un plan principal du support 101 et parallèle au vecteur $\bar{k}$ du repère $[O; \bar{i}; \bar{j}; \bar{k}]$ défini sur la figure 1A) par exemple comprise entre 2 et 50 nanomètres, par exemple de l'ordre de 20 nanomètres.

Les couches $105_1,...,105_n$ à base de matériau ferromagnétique peuvent, quant à elles, avoir une épaisseur t (également mesurée dans une direction parallèle au vecteur $\bar{k}$) par exemple comprise entre 2 et 40 nanomètres, par exemple de l'ordre de 10.

L'empilement 108 peut avoir une épaisseur totale par exemple de l'ordre de 200 à 600 nanomètres.

Ensuite, on réalise des motifs dans l'empilement 108 de couches, en effectuant une gravure des couches par exemple de type IBE (IBE pour « Ion Beam Etching »).

On forme ainsi au moins trois blocs 111, 112, 113, distincts et disjoints, chacun étant formé de l'empilement de couches de matériau anti-ferromagnétique AF et de matériau ferro-magnétique F (figure 1B).

Les blocs 111, 112, 113, ont chacun une forme allongée ou longiligne.

Les blocs 111, 112, 113, peuvent être, par exemple, chacun sous forme d'un parallélépipède rectangle (figure 1B).

Les blocs 111, 112, 113 peuvent avoir une largeur W (mesurée dans un plan parallèle au plan $[O; \bar{i}; \bar{j}]$) par exemple comprise entre 20 et 500 micromètres, par exemple de l'ordre de 20 micromètres.

La longueur L (mesurée dans un plan parallèle au plan $[O; \bar{i}; \bar{j}]$) par exemple comprise entre 20 et 500 micromètres, par exemple de l'ordre de 100 micromètres.

Le rapport d'aspect L/W entre la longueur et la largeur des blocs peut être prévu important et par exemple d'au moins 5.

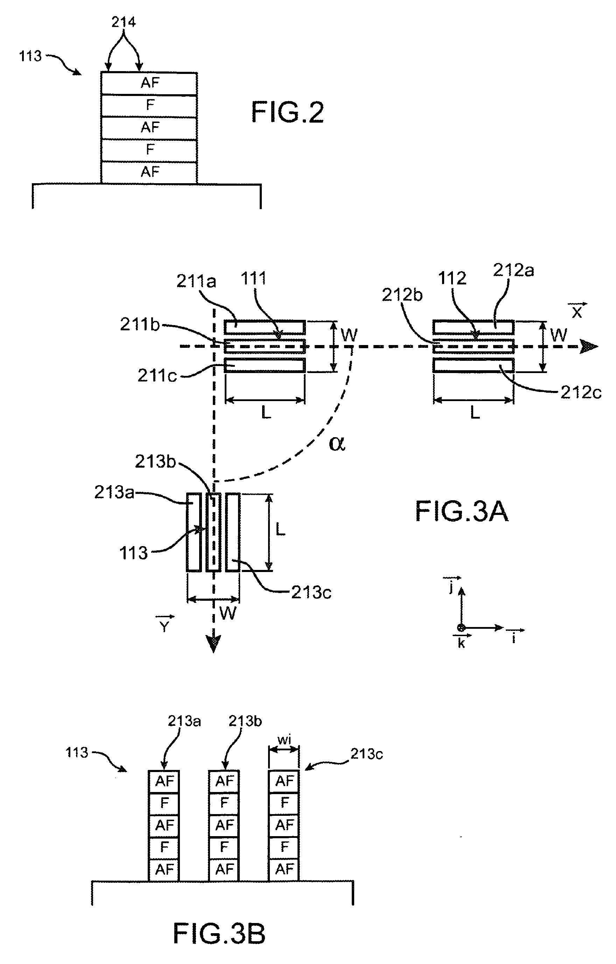

Selon une variante, un ou plusieurs des blocs 111, 112, 113 peuvent être sous forme d'un ensemble de sous-blocs parallélépipédiques rectangles 211a, 211b, 211c, 212a, 212b, 212c, 213a, 213b, 213c parallèles et disjoints entre eux (figures 3A et 3B).

Subdiviser les blocs 211, 212, 213 en sous-blocs parallélépipédiques, ayant en particulier chacun un rapport d'aspect avec une longueur L sur une largeur wi important par exemple avec $w_i/L \geq 10$, permet de garantir un bon alignement des aimantations le long de leurs directions principales respectives.

Les sous-blocs 211a, 211b, 211c, 212a, 212b, 212c, 213a, 213b, 213c peuvent être d'avoir une largeur Wi comprise par exemple entre 0,25 $\mu$m et 10 $\mu$m et préférentiellement inférieure à 5 $\mu$m.

Au moins deux blocs 111, 113, 211a, 213a gravés dans l'empilement 108, sont orientés selon des directions principales différentes (les directions principales des blocs 111, 113 étant définies par des axes $\vec{X}$ et $\vec{Y}$ sur la figure 1B), réalisant entre elles un angle $\alpha$ par exemple de 90˚. Certains blocs 111, 112, 211a, 212a sont orientés selon des directions principales respectives parallèles entre elles, ou dans une même direction.

Ensuite, une fois les blocs 111, 112, 113 formés, on effectue un recuit de mise en ordre magnétique, dont la température est prévue de manière à réaliser une mise en ordre du matériau anti-ferromagnétique.

Lorsque le matériau antiferromagnétique AF est un matériau anti-ferromagnétique non ordonné, par exemple du type NiMn, ou PtMn, ou PdPtMn, c'est à dire un matériau qui ne présente pas de couplage d'échange après dépôt, l'étape de recuit est effectuée à une température supérieure ou égale à la température de mise en ordre de ce matériau. Cette température de mise en ordre est typiquement au dessus de 250˚C.

Pour un matériau antiferromagnétique AF ordonné tel que du FeMn, ou du IrMn, ou du NiO, ou du $Fe_2O_3$, c'est-à-dire qui présente un couplage d'échange après dépôt, l'étape de recuit est effectuée au dessus de la température de blocage ou de la température de Néel de ce matériau soit typiquement entre 150˚C et 250˚C.

Le recuit peut être effectué par exemple à une température supérieure à 260˚C lorsque le matériau anti-ferromagnétique est du PtMn.

Le recuit peut être réalisé de sorte que pendant ce dernier, en particulier au début de ce dernier, on applique un champ magnétique $\overline{B}$, orienté de manière à réaliser un angle $\theta$ non-nul, qui peut être de 45˚, par rapport aux directions principales $\overline{X}$ et $\overline{Y}$ des blocs 111, 113.

Le champ magnétique appliqué peut être un champ saturant d'intensité $\|\overline{B}\|$=Bsat prévue supérieure à une valeur prédéterminée de champ correspondant au champ de saturation des blocs selon leur axe difficile.

L'axe difficile est l'axe pour lequel le champ magnétique appliqué pour aligner l'aimantation du bloc est le plus important.

Pour saturer l'aimantation et éliminer tous les domaines du bloc 111 on applique à ce dernier un champ saturant supérieur ou égal au champ de saturation selon $\overline{Y}$.

Pour saturer l'aimantation et éliminer tous les domaines du bloc 111 lorsque celui-ci est divisé en sous blocs 211a, 211b, 211c on applique à ce dernier un champ saturant supérieur ou égal au champ de saturation d'un sous bloc selon $\overline{Y}$.

Dans un cas où l'on met en oeuvre des blocs de largeurs différentes un champ magnétique saturant supérieur au champ de saturation du bloc de plus faible largeur est appliqué.

Le champ saturant appliqué peut être très supérieur à ladite valeur prédéterminée, et peut être par exemple de l'ordre 1T ou 2T (figure 1C).

On réduit ensuite l'intensité du champ magnétique appliqué, de sorte que le module du champ magnétique appliqué projeté le long d'un axe $\overline{X}$, correspondant à l'axe dans lequel la longueur des blocs 111 et 112 est mesurée, est supérieur ou égal au champ de saturation $H_L$ des blocs 111, 112, orientés selon leur axe facile d'aimantation, le module du champ magnétique appliqué projeté le long d'un axe $\overline{Y}$, correspondant à l'axe dans lequel la longueur du bloc 113 est mesurée, est supérieur ou égal au champ de saturation $H_L$ du bloc 113, selon son axe facile d'aimantation.

Le module du champ magnétique appliqué projeté le long d'un axe $\overline{Y}$ correspondant à l'axe dans lequel la largeur des blocs 111 et 112 est mesurée, est inférieur au champ de saturation $H_w$ des blocs selon leur axe difficile d'aimantation.

Le module du champ magnétique appliqué projeté le long d'un axe $\overline{X}$ correspondant à l'axe dans lequel la largeur du bloc 113 est mesurée, est inférieur au champ de saturation $H_w$ selon l'axe difficile d'aimantation du bloc 113.

Le module du champ magnétique appliqué projeté le long de l'axe $\overline{Y}$ peut être prévu 20 fois plus faible que le champ de saturation $H_w$ des blocs 111, 112 selon leur axe difficile d'aimantation, afin de garantir un alignement des aimantations dans les blocs 111, 112 à 5˚ de leur direction principale.

Le champ de saturation $H_L$ d'un bloc parallélépipédique de direction principale orientée selon un axe $\overline{X}$ correspondant à la direction dans laquelle sa longueur L est mesurée peut être évalué à l'aide de la formule suivante :

$$H_L = \frac{Wt}{L^2}\left[\ln\left(\frac{4L}{W}\right)-1\right] * 4 * \pi * Ms$$

Le champ de saturation $H_w$ de ce même bloc selon l'axe $\overline{Y}$ peut être évalué à l'aide la formule suivante :

$$Hw = 4 * \pi * Ms * t * \left[ \frac{1}{t+W} - \frac{W}{L^2} \left[ \ln\left(\frac{4L}{W}\right) - 1 \right] \right]$$

où t est l'épaisseur de l'ensemble des couches Ferromagnétiques du bloc, Ms l'aimantation à saturation, L est la longueur du bloc et W sa largeur.

Ainsi, par exemple pour des blocs 111, 112 de 100 $\mu$m de longueur, de 2 $\mu$m de largeur et de 100 nanomètres d'épaisseur, on a

$$H_L = 1 \ G$$

et

$$H_W = 513 \ G.$$

En appliquant un champ de 30 G à 45° on peut obtenir une orientation de l'aimantation à mieux que 5° du grand axe d'un bloc quelque soit son orientation.

Le module du champ projeté le long de la deuxième direction principale est de préférence inférieur à 5% de Hw afin de garantir un alignement meilleur que 5° par rapport à la première direction principale et inférieur à 2% pour un alignement meilleur que 2° par rapport à la première direction principale.

Dans un cas où les blocs 111, 112 sont de largeurs différentes alors on obtiendra des alignements différents par rapport aux directions principales de chaque bloc.

Par exemple, si le bloc 111 a une première largeur W = W1 = 10 $\mu$m et que le bloc 112 a une deuxième largeur W = W2 = 2 $\mu$m, les blocs 111, 112 ayant chacun une longueur L = 100 $\mu$m et qu'on applique par exemple un champ magnétique de 30G l'aimantation dans le bloc 111 sera désalignée de ~20° par rapport à sa direction principale alors que le désalignement ne sera que de 5° dans le bloc 112.

Le tableau ci-dessous donne des exemples de champs à appliquer pour assurer un alignement de 5° ou 2°en fonction des dimensions des blocs.

| ALIGNEMENT A 5° | | | | | | |
|---|---|---|---|---|---|---|
| Longueur | 100 | 100 | 100 | 100 | 100 | 100 |
| Largeur | 10 | 5 | 2 | 1 | 0,25 | 0,25 |
| H$_L$ | 105 | 210 | 513 | 981 | 1800 | 3087 |
| H$_w$ | 3 | 1,8 | 0,9 | 0,5 | 0,3 | 0,17 |
| Module de H pour 0 = 45° | 7 | 14 | 33 | 63 | 116 | 199 |
| ALIGNEMENT A 2° | | | | | | |
| Longueur | 100 | 100 | 100 | 100 | 100 | 100 |
| Largeur | 10 | 5 | 2 | 1 | 0,5 | 0,25 |
| H$_L$ | 105 | 210 | 513 | 981 | 1800 | 3087 |
| H$_w$ | 3 | 1,8 | 0,9 | 0,5 | 0,3 | 0,17 |
| Module de H pour 0 = 45° | 3 | 5 | 13 | 25 | 45 | 78 |

Pour ne pas avoir à mettre en oeuvre des champs magnétiques trop faibles dans le four de recuit il peut être préférable de mettre en oeuvre des blocs de largeur W inférieure à 2 $\mu$m.

Ensuite, on réduit la température de recuit afin de générer dans chaque bloc, un échange entre le matériau antiferromagnétique AF et le matériau ferromagnétique F, ce qui permet de figer définitivement les directions d'aimantation.

A l'issue du recuit, on obtient des blocs 111 et 112 ayant une orientation d'aimantation identiques dans une direction qui peut être sensiblement parallèle à celle de l'axe X ou différer de moins de 5° de celle de l'axe X, tandis que le bloc 113 a une aimantation d'orientation différente, qui est sensiblement orthogonale à celle des blocs 111 et 112.

Un capteur de champ magnétique tri-axe, par exemple de type à jauge de contrainte peut être formé à partir du dispositif ainsi réalisé.

Pour cela, selon un exemple, on peut notamment déposer une couche de passivation sur le dispositif excepté à l'emplacement au niveau duquel une jauge de contrainte est destinée à être suspendue.

Puis, on réalise cette jauge, qui peut être métallique, par dépôt puis gravure.

Un dépôt d'une couche de protection sur l'ensemble du dispositif, destinée à protéger notamment la jauge de contrainte peut être ensuite réalisé.

On forme ensuite des ouvertures dans la couche de protection et notamment au-dessus des extrémités libres de la jauge de contrainte afin de réaliser les contacts électriques par dépôt métallique.

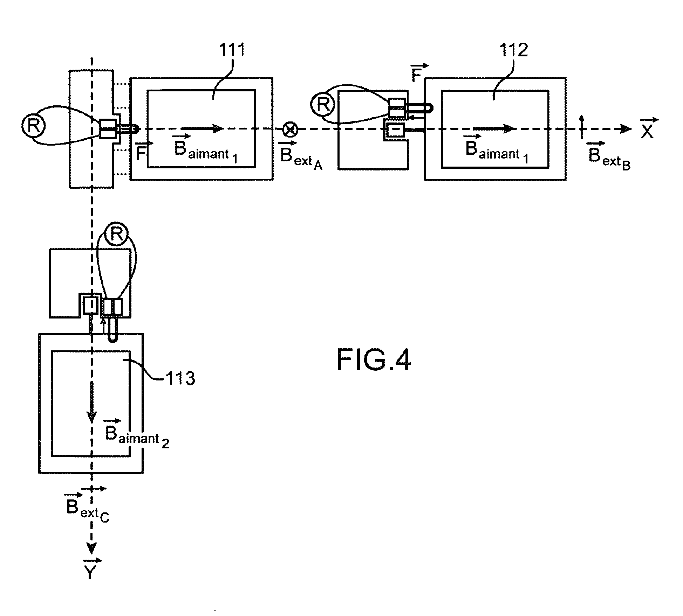

Un exemple de capteur de mesure d'un champ magnétique comportant des composantes selon 3 axes perpendiculaires les uns par rapport aux autres, c'est-à-dire réalisant une mesure de champ magnétique selon trois directions, est représenté sur la figure 4.

Ce capteur comporte une première structure formée à partir du premier bloc 111, qui est apte à mesurer une composante $\overline{B}_{extA}$ du champ magnétique à mesurer, parallèle à un axe orthogonal au plan principal du substrat, c'est-à-dire orthogonal aux axes $\overline{X}$ et $\overline{Y}$.

Le capteur comporte en outre une deuxième structure formée à partir du bloc 112, apte à mesurer une composante $\overline{B}_{extB}$ du champ magnétique parallèle à l'axe $\overline{Y}$, ainsi qu'une troisième structure 113 qui comporte les mêmes éléments que la seconde structure. Ainsi, la jauge de contrainte de cette troisième structure, qui subie une force de compression ou de tension parallèle à l'axe Y, est donc apte à mesurer une composante $B_{extc}$ du champ magnétique parallèle à l'axe $\overline{X}$. Le bloc magnétique 113 de cette troisième structure a une orientation magnétique $B_{aimant2}$ perpendiculaire à l'orientation magnétique $B_{aimant1}$ de celui des blocs 111, 112 de la première et de la deuxième structure.

Si un champ magnétique perturbateur fort comme celui d'un aimant venait renverser l'orientation d'aimantation des blocs 111, 112 ou 113, cette orientation serait restaurée dès que l'aimant serait éloigné du dispositif. Le long du petit axe, l'aimantation pourrait tourner en présence d'une perturbation magnétique mais retournerait à sa position initiale en fin de perturbation.

**Revendications**

1. Procédé de réalisation d'un dispositif comportant des blocs magnétiques (111, 112, 113, 211a, 211b, 211c, 212a, 212b, 212c, 213a, 213b, 213c) reposant sur un substrat (100) et qui sont aimantés selon des directions différentes, comprenant:

   a) une étape de formation dans un empilement (108) d'une ou plusieurs couches ($104_1$, $104_2$, $104_3$) de matériau anti-ferromagnétique et d'une ou plusieurs couches de matériau ferromagnétique ($105_1$, $105_2$) reposant sur un substrat, d'au moins un premier bloc et au moins un deuxième bloc disjoints, le premier bloc et le deuxième bloc étant longilignes et s'étendant respectivement selon une première direction principale et selon une deuxième direction principale, la première et la deuxième direction principale réalisant entre elles un premier angle $\alpha$ non-nul,

   b) une étape de recuit desdits blocs à une température supérieure à la température de mise en ordre ou à la température de blocage ou à la température de Néel du dit matériau anti-ferromagnétique, cette étape de recuit comportant en outre, lors du recuit, l'application d'un champ magnétique orienté dans une direction réalisant un deuxième angle $\theta$ non-nul avec lesdites première et deuxième directions principales, et d'intensité que l'on fait varier au cours du recuit, de sorte que, lors de l'application du champ magnétique :

   - on applique tout d'abord un champ magnétique d'intensité donnée supérieure à celle du champ magnétique de saturation $H_W$ des blocs selon leur axe difficile d'aimantation,
   - on diminue ensuite l'intensité donnée, de sorte que les modules respectifs d'une projection du champ magnétique selon la première direction principale et d'une projection du champ magnétique selon la deuxième direction principale, sont supérieurs à une valeur de champ de saturation $H_L$ des blocs selon leur axe facile d'aimantation, et les modules respectifs d'une projection du champ magnétique perpendiculaire à la première direction principale, et d'une projection du champ magnétique, perpendiculaire à la deuxième direction principale, sont inférieurs à une valeur de champ de saturation $H_W$ des blocs selon leur axe difficile d'aimantation.

2. Procédé selon la revendication 1, dans lequel, après le recuit, on maintient l'application dudit champ magnétique tout en laissant refroidir lesdits blocs.

3. Procédé selon l'une des revendications 1 ou 2, dans lequel le premier angle α est de 90˚, le deuxième angle θ étant de 45˚.

4. Procédé selon l'une des revendications 1 à 3, dans lequel :

$$ H_L = \frac{Wt}{L^2}\left[ \ln\left(\frac{4L}{W}\right) - 1 \right] * 4 * \pi * Ms $$

$$ Hw = 4 * \pi * Ms * t * \left[ \frac{1}{t+W} - \frac{W}{L^2}\left[ \ln\left(\frac{4L}{W}\right) - 1 \right] \right] $$

avec t l'épaisseur du bloc, L la longueur du bloc, W la largeur du bloc, Ms l'aimantation à saturation.

5. Procédé selon l'une des revendications 1 à 4, l'empilement comprenant au moins une couche ferromagnétique (F) située entre, et en contact, avec deux couches antiferromagnétiques (AF).

6. Procédé selon l'une des revendications 1 à 5, dans lequel, lors de l'étape a), on forme en outre, dans un empilement (108), au moins un troisième bloc longiligne, s'étendant selon la première direction principale.

7. Procédé selon l'une des revendications 1 à 6, dans lequel au moins un des dits blocs (111, 112, 113) est lui même sous forme d'une pluralité de blocs parallélépipédiques (211a, 211b, 211c, 212a, 212b, 212c, 213a, 213b, 213c) distincts et parallèles entre eux.

8. Procédé de réalisation d'un capteur magnétique tri-axes comprenant la mise en oeuvre d'un procédé selon l'une des revendications 1 à 7.

**Claims**

1. Method for producing a device comprising magnetic blocks (111, 112, 113, 211a, 211b, 211c, 212a, 212b, 212c, 213a, 213b, 213c) resting on a substrate (100) and which are magnetized in different directions, said method comprising:

   a) a step of forming, in a stack (108) of one or more layers ($104_1$, $104_2$, $104_3$) of antiferromagnetic material and one or more layers of ferromagnetic material ($105_1$, $105_2$) resting on a substrate, at least one first block and at least one second block, said blocks being separate, the first block and the second block being longilineal and extending respectively in a first main direction and in a second main direction, the first and the second main direction forming between them a first non-zero angle α,

   b) a step of annealing said blocks at a temperature greater than the ordering temperature or than the blocking temperature or than the Néel temperature of said antiferromagnetic material, this annealing step additionally comprising, during the annealing, the application of a magnetic field oriented in a direction that forms a second non-zero angle θ with said first and second main directions, and of an intensity that is varied during the annealing, so that during the application of the magnetic field:

      - first of all there is applied a magnetic field of given intensity greater than that of the saturation magnetic field $H_w$ of the blocks along their hard magnetization axis,
      - the given intensity is then reduced so that the respective moduli of a projection of the magnetic field in the first main direction and of a projection of the magnetic field in the second main direction are greater than a saturation field value $H_L$ of the blocks along their easy magnetization axis, and the respective moduli of a projection of the magnetic field perpendicular to the first main direction and of a projection of the magnetic field perpendicular to the second main direction are lower than a saturation field value $H_w$ of the blocks along their hard magnetization axis.

2. Method according to claim 1, in which, after the annealing, the application of said magnetic field is maintained while allowing said blocks to cool.

3. Method according to one of claims 1 or 2, in which the first angle $\alpha$ is 90˚, the second angle $\theta$ being 45˚.

4. Method according to one of claims 1 to 3, in which:

$$H_L = \frac{Wt}{L^2}\left[\ln\left(\frac{4L}{W}\right)-1\right]*4*\pi*Ms$$

$$Hw = 4*\pi*Ms*t*\left[\frac{1}{t+W}-\frac{W}{L^2}\left[\ln\left(\frac{4L}{W}\right)-1\right]\right]$$

where t is the thickness of the block, L is the length of the block, W is the width of the block and Ms is the saturation magnetization.

5. Method according to one of claims 1 to 4, the stack comprising at least one ferromagnetic layer (F) located between, and in contact with, two antiferromagnetic layers (AF.

6. Method according to one of claims 1 to 5, in which, during step a), there is additionally formed in a stack (108) at least a third longilineal block extending in the first main direction.

7. Method according to one of claims 1 to 6, in which at least one of said blocks (111, 112, 113) is itself in the form of a plurality of parallelepiped blocks (211a, 211b, 211c, 212a, 212b, 212c, 213a, 213b, 213c) that are separate from and parallel to one another.

8. Method for producing a three-axis magnetic sensor, comprising the implementation of a method according to one of claims 1 to 7.

**Patentansprüche**

1. Verfahren zur Herstellung einer Vorrichtung, die magnewtische Blöcke (111, 112, 113, 211a, 211b, 211c, 212a, 212b, 212c, 213a, 213b, 213c) aufweist, die auf einem Substrat (100) angeordnet sind und die in unterschiedliche Richtungen magnetisiert sind, mit:

a) einem Schritt zum Bilden mindestens eines ersten Blocks und mindestens eines zweiten Blocks, die voneinander getrennt sind, in einem Stapel (108), der aus einer oder mehreren Schichten ($104_1$, $104_2$, $104_3$) eines antiferromagnetischen Materials und einer oder mehreren Schichten ($105_1$, $105_2$) eines ferromagnetischen Materials besteht, die auf einem Substrat angeordnet sind, wobei der erste Block und der zweite Block länglich sind und sich jeweils in eine erste Hauptrichtung und in eine zweite Hauptrichtung erstrecken, wobei die erste und die zweite Hauptrichtung zwischen sich einen ersten Winkel $\alpha$ von ungleich Null bilden,
b) einem Schritt zum Glühen der Blöcke bei einer Temperatur, die höher ist als die Einordnungstemperatur oder die Verriegelungstemperatur oder die Néel-Temperatur des antiferromagnetischen Materials, wobei dieser Glühschritt außerdem beim Glühen das Anlegen eines Magnetfelds umfasst, das in eine Richtung ausgerichtet ist, die mit der ersten und der zweiten Hauptrichtung einen zweiten Winkel $\theta$ von ungleich Null bildet, und das eine Intensität aufweist, die während des Glühens verändert wird, so dass beim Anlegen des Magnetfelds

- zuerst ein Magnetfeld einer vorgegebenen Intensität angelegt wird, die höher ist als diejenige des Sättigungsmagnetfelds $H_W$ der Blöcke entlang ihrer schweren Magnetisierungsachse,
- anschließend die vorgegebene Intensität verringert wird, so dass die jeweiligen Module einer Projektion des Magnetfelds in die erste Hauptrichtung und einer Projektion des Magnetfelds in die zweite Hauptrichtung größer sind als ein Sättigungsfeldwert $H_L$ der Blöcke entlang ihrer leichten Magnetisierungsachse, und dass die jeweiligen Module einer Projektion des Magnetfelds senkrecht zur ersten Hauptrichtung und einer Projektion des Magnetfelds senkrecht zur zweiten Hauptrichtung kleiner sind als ein Sättigungsfeldwert $H_w$ der Blöcke entlang ihrer schweren Magnetisierungsachse.

2. Verfahren nach Anspruch 1, in welchem nach dem Glühen das Magnetfeld weiterhin angelegt bleibt, währenddessen die Blöcke abkühlen.

3. Verfahren nach einem der Ansprüche 1 oder 2, in welchem der erste Winkel $\alpha$ 90˚ beträgt und der zweite Winkel $\theta$ 45˚ beträgt.

4. Verfahren nach einem der Ansprüche 1 bis 3, in welchem

$$H_L = \frac{Wt}{L^2}\left[\ln\left(\frac{4L}{W}\right) - 1\right] * 4 * \pi * Ms$$

$$Hw = 4 * \pi * Ms * t * \left[\frac{1}{t+W} - \frac{W}{L^2}\left[\ln\left(\frac{4L}{W}\right) - 1\right]\right]$$

mit t = Dicke des Blocks, L = Länge des Blocks, W = Breite des Blocks und Ms = Magnetisierung bis zur Sättigung.

5. Verfahren nach einem der Ansprüche 1 bis 4, wobei der Stapel mindestens eine ferromagnetische Schicht (F) aufweist, die zwischen und in Kontakt mit zwei antiferromagnetischen Schichten (AF) angeordnet ist.

6. Verfahren nach einem der Ansprüche 1 bis 5, wobei während des Schritts a) in einem Stapel (108) außerdem mindestens ein dritter länglicher Block gebildet wird, der sich in die erste Hauptrichtung erstreckt.

7. Verfahren nach einem der Ansprüche 1 bis 6, wobei mindestens einer der Blöcke (111, 112, 113) selbst wiederum in Form mehrerer einzelner und zueinander paralleler Quaderblöcke (211a, 211b, 211c, 212a, 212b, 212c, 213a, 213b, 213c) ist.

8. Verfahren zum Herstellern eines Dreiachsen-Magnetsensors unter Anwendung eines Verfahrens nach einem der Ansprüche 1 bis 7.

108

104₃

AF

t

F

105₂

AF

104₂

F

105₁

t'

AF

104₁

101

k

j

o

i

## FIG.1A

111

112

x

W

W

L

L

j

k

i

113

L

W

Y

## FIG.1B

111

112

x

$\| B \| = B_{sat}$

113

Y

## FIG.1C

214

113

| AF |
|----|
| F |
| AF |
| F |
| AF |

FIG.2

211a    111              212b  112    212a    $\overrightarrow{X}$

211b

W

211c

L                                   L                  212c

α

213b

213a

L

113

W                                   FIG.3A

Y                                   213c

$\overrightarrow{j}$

$\overrightarrow{k}$   $\overrightarrow{i}$

213a    213b    wi

113                      213c

| AF | AF | AF |
|----|----|----|
| F  | F  | F  |
| AF | AF | AF |
| F  | F  | F  |
| AF | AF | AF |

FIG.3B

FIG.4

**EP 2 341 358 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040137275 A